# EUROPÄISCHE PATENTANMELDUNG

(11) **EP 1 187 215 A2**
(43) Veröffentlichungstag der Anmeldung: **13.03.2002**
(21) Anmeldenummer: 01119172.3
(22) Anmeldetag: 08.08.2001
(51) Int. Cl.: H01L 27/115, H01L 21/8246

(54) **Vertikale nichtflüchtige Halbleiter-Speicherzelle sowie Verfahren zu deren Herstellung**

(30) Priorität: 27.08.2000 DE 10041749
(71) Anmelder: Infineon Technologies AG, 81669 München (DE)
(72) Erfinder: Gratz, Achim, 98587 Steinbach-Hallenberg (DE)
(74) Vertreter: Kindermann, Peter, Dipl.-Ing.

(57) **Zusammenfassung**

Die Erfindung betrifft eine vertikale nichtflüchtige Halbleiter-Speicherzelle sowie ein dazugehöriges Herstellungsverfahren, bei dem unterhalb der vertikalen Halbleiter-Speicherzelle mit ihrer ersten dielektrischen Schicht (8), ihrer Ladungsspeicherschicht (9), ihrer zweiten dielektrischen Schicht (10) und ihrer Steuerschicht (11) ein Grabenfortsatz (5') ausgebildet ist, der eine dritte dielektrische Schicht (6) sowie ein Füllmaterial (7) aufweist. Auf diese Weise können die Datenhalteeigenschaften sowie ein Koppelfaktor verbessert werden.

## Beschreibung

Die vorliegende Erfindung bezieht sich auf eine vertikale nichtflüchtige Halbleiter-Speicherzelle sowie ein dazugehöriges Herstellungsverfahren und insbesondere auf eine EPROM-, EEPROM- und FLASH-EEPROM-Speicherzelle mit geringem Flächenbedarf.

Wiederbeschreibbare nichtflüchtige Halbleiter-Speicherzellen gewinnen in hochintegrierten Schaltungen zunehmend an Bedeutung, da sie beispielsweise in Chipkarten, Multimediakarten und sogenannten Smartcards veränderbare Daten über einen langen Zeitraum und ohne Verwendung einer Spannungsversorgung speichern können. Die verschiedenen Anwendungen führen zu unterschiedlichen Anforderungsprofilen, die unterschiedliche technologische Realisierungen erfordern. Von zunehmender Bedeutung sind hierbei sogenannte eingebettete nichtflüchtige Speicher, bei denen die nichtflüchtige Speicherfunktion gleichzeitig mit weiteren Funktionen unter Beachtung von deren Anforderungsprofilen auf demselben Chip realisiert wird.

Je nach Art der verwendeten nichtflüchtigen Halbleiter-Speicherzellen, insbesondere dem zugrundeliegenden Programmier- und Löschverfahren, unterscheidet man grundsätzlich zwischen EPROMs, EEPROMs und FLASH-EEPROM-Speichern. Für eingebettete Speicher kommen fast ausschließlich elektrisch programmier- und löschbare sowie mehrfach wiederbeschreibbare Speicher in Betracht (EEPROM, FLASH).

Für diese Anwendungen bekannte, herkömmliche nichtflüchtige Halbleiter-Speicherzellen bestehen üblicherweise aus einem Halbleitersubstrat, einer isolierenden Tunneloxidschicht, einer Floating-Gate-Schicht bzw. Ladungsspeicherschicht, einer isolierenden dielektrischen Schicht und einer leitenden Steuerschicht, welche an der Oberfläche des Halbleitersubstrats ausgebildet sind. Zur Speicherung von Informationen werden Ladungen von einem im Halbleitersubstrat ausgebildeten Kanalbereich über die Tunneloxidschicht in die Floating-Gate-Schicht eingebracht. Verfahren zum Einbringen der Ladungen in die Floating-Gate-Schicht sind beispielsweise Injektion heißer Ladungsträger und Fowler-Nordheim-Tunneln.

Nachteilig bei derartigen herkömmlichen nichtflüchtigen Halbleiter-Speicherzellen ist jedoch zum einen der relativ hohe Platzbedarf, der sich insbesondere durch die Ausbildung an der Oberfläche des Halbleitersubstrats ergibt. Zum anderen läßt sich der Platzbedarf nicht wie bei Logiktechnologien bekannt durch sogenanntes Skalieren bzw. Shrinken verkleinern, da die minimalen Strukturgrößen zum großen Teil durch die aufgrund des physikalischen Mechanismus benötigten Spannungen zum Programmieren und Löschen festgelegt sind.

Zur weiteren Flächenreduzierung werden daher zunehmend dreidimensionale Anordnungen für nichtflüchtige Halbleiter-Speicherzellen vorgeschlagen, wobei beispielsweise die isolierende Tunneloxidschicht, die Floating-Gate-Schicht sowie die Steuerschicht vertikal im Halbleitersubstrat angeordnet sind.

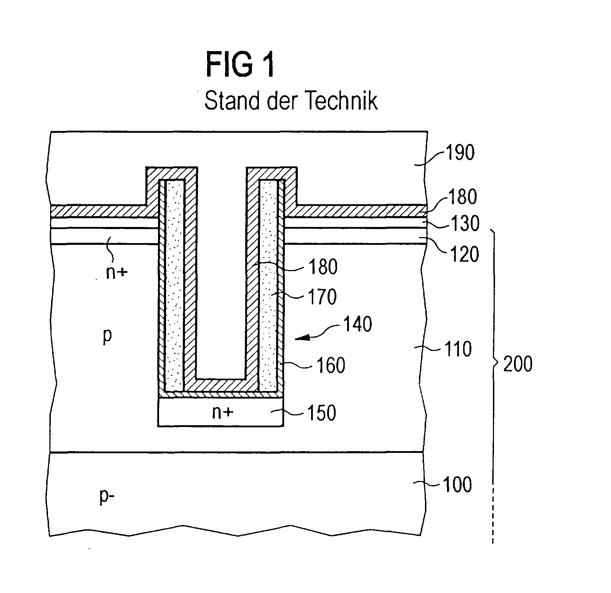

Figur 1 zeigt eine Schnittansicht einer derartigen vertikalen nichtflüchtigen Halbleiter-Speicherzelle, wie sie beispielsweise aus der Druckschrift WO97/02599 bekannt ist. Gemäß dieser Druckschrift wird in einem Halbleitersubstrat 200, welches beispielsweise ein schwach dotiertes p-Gebiet 100, eine p-dotierte Wanne 110 und ein stark dotiertes n⁺-Gebiet 120 aufweist, mittels einer Hilfsschicht 130 und einer nicht dargestellten Maskenschicht wird im Halbleitersubstrat 200 ein Graben 140 ausgebildet, an dessen Boden ein weiteres stark dotiertes n⁺-Gebiet 150 ausgebildet wird. Die stark dotierten n⁺-Gebiete 150 und 120 stellen hierbei sogenannte Drain- und Sourcegebiete der vertikalen nichtflüchtigen Halbleiter-Speicherzelle dar. An den Wanden und am Boden des Grabens 140 ist als dielektrische Schicht eine Tunneloxidschicht 160 ausgebildet. Daran anschließend befindet sich die Floating-Gate-Schicht 170 zum Speichern von Ladungen sowie eine zweite dielektrische Schicht 180, welche sich aus einer ONO-Schichtenfolge zusammensetzt. Zur Ansteuerung der nichtflüchtigen Halbleiter-Speicherzelle befindet sich auf der zweiten dielektrischen Schicht 180 eine Steuerschicht 190, welche gemäß Figur 1 aus hochdotiertem Polysilizium besteht.

Auf diese Weise erhält man eine vertikale nichtflüchtige Halbleiter-Speicherzelle mit einem verringertem Flächenbedarf, da sich nunmehr die minimal notwendige Kanallänge der Speicherzelle vertikal im Halbleitersubstrat 200 erstreckt und eine weitergehende Verringerung der Strukturgrößen an der Oberfläche des Halbleitersubstrats ermöglicht ist. Nachteilig bei einer derartigen herkömmlichen vertikalen nichtflüchtigen Halbleiter-Speicherzelle sind jedoch die geringen Datenhalteeigenschaften, die sich insbesondere aus einem Ladungsverlust in Richtung zum Halbleitersubstrat 200 ergeben.

Der Erfindung liegt daher die Aufgabe zu Grunde, eine vertikale nichtflüchtige Halbleiter-Speicherzelle sowie ein dazugehöriges Herstellungsverfahren zu schaffen, bei dem man verbesserte Datenhalteeigenschaften bzw. eine verbesserte "retention time" erhält.

Erfindungsgemäß wird diese Aufgabe hinsichtlich der Halbleiter-Speicherzelle durch die Merkmale des Patentanspruchs 1 und hinsichtlich des Verfahrens durch die Maßnahmen des Patentanspruchs 13 gelöst.

Insbesondere durch die Verwendung eines Grabenfortsatzes, der im Wesentlichen unterhalb eines Grabens ausgebildet ist, in dem sich die vertikale nichtflüchtige Halbleiter-Speicherzelle befindet, erhält man auf besonders kostengünstige Art und Weise stark verbesserte Datenhalteeigenschaften, da ein Ladungsverlust von einer ladungsspeichernden Schicht in ein Substrat stark verringert ist. Der Grabenfortsatz besitzt hierbei eine dritte dielektrische Schicht an seiner Grabenoberfläche und ist mit einem isolierenden oder elektrisch leitfähigen Füllmaterial zumindest teilweise aufgefüllt.

Eine weitere Verbesserung der Datenhalteeigenschaften erhält man im Falle elektrisch leitfähigen Füllmaterials durch eine zusätzliche Isolierung der Ladungsspeicherschicht der Halbleiter-Speicherzelle vom Füllmaterial des Grabenfortsatzes. Die "retention time" kann dadurch weiter verbessert werden.

Alternativ bzw. zur Verringerung der Kosten kann jedoch diese zusätzliche Isolierung zwischen Füllmaterial und Ladungsspeicherschicht auch entfallen, wobei sich bei geeigneter Gestaltung der dritten dielektrischen Schicht an der Oberfläche des Grabenfortsatzes weiter sehr gute Datenhalteeigenschaften für die nichtflüchtige Halbleiter-Speicherzelle ergeben.

Zur Optimierung eines Koppelfaktors kann sich eine zweite dielektrische Schicht und eine Steuerschicht sowohl innerhalb des Grabens, als auch innerhalb des Grabenfortsatzes sowie bis hin zum Substrat erstrecken, wodurch in Abhängigkeit von einem jeweiligen Layout und dazugehörigen parasitären Kapazitäten minimale Programmierspannungen eingestellt werden können.

Vorzugsweise besteht eine erste dielektrische Schicht aus einer Tunnelschicht und eine zweite und dritte dielektrische Schicht aus einer ONO-Schichtenfolge, wodurch die vertikale nichtflüchtige Halbleiter-Speicherzelle auf besonders kostengünstige und einfache Art und Weise hergestellt werden kann.

Zur weiteren Verbesserung des Koppelfaktors kann die zweite dielektrische Schicht jedoch auch ein Dielektrikum mit besonders hoher relativer Dielektrizitätskonstante aufweisen, wobei insbesondere Materialien aus Metalloxid verwendet werden. Die erforderlichen Betriebs- und Einsatzspannungen können auf diese Art und Weise weiter verringert werden.

Insbesondere bei Verwendung eines DRAM-Prozesses zum Ausbilden von tiefen Gräben kann die erfindungsgemäße vertikale nichtflüchtige Halbleiter-Speicherzelle besonders kostengünstig hergestellt werden. Der untere Teil des tiefen Grabens realisiert hierbei den Grabenfortsatz, während der obere Teil die eigentliche nichtflüchtige Halbleiter-Speicherzelle beinhaltet. Ferner ergibt sich auf diese Art und Weise eine besonders kostengünstige Möglichkeit, nichtflüchtige Halbleiter-Speicherzellen mit dynamischen Halbleiter-Speicherzellen in sogenannten Embedded-DRAM-Prozessen zu kombinieren.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine vereinfachte Schnittansicht einer herkömmlichen vertikalen nichtflüchtigen Halbleiter-Speicherzelle;
- Figur 2: eine vereinfachte Schnittansicht einer erfindungsgemäßen vertikalen nichtflüchtigen Halbleiter-Speicherzelle gemäß einem ersten Ausführungsbeispiel;
- Figur 3: eine vereinfachte Schnittansicht einer erfindungsgemäßen vertikalen nichtflüchtigen Halbleiter-Speicherzelle gemäß einem zweiten Ausführungsbeispiel;

- Figur 4: eine vereinfachte Schnittansicht einer erfindungsgemäßen vertikalen nichtflüchtigen Halbleiter-Speicherzelle gemäß einem dritten Ausführungsbeispiel;
- Figur 5: eine vereinfachte Schnittansicht einer erfindungsgemäßen vertikalen nichtflüchtigen Halbleiter-Speicherzelle gemäß einem vierten Ausführungsbeispiel;
- Figur 6: eine vereinfachte Schnittansicht einer erfindungsgemäßen EEPROM-Speicherzelle gemäß einem fünften Ausführungsbeispiel; und
- Figur 7: ein Ersatzschaltbild der in Figur 6 dargestellten erfindungsgemäßen EEPROM-Speicherzelle.

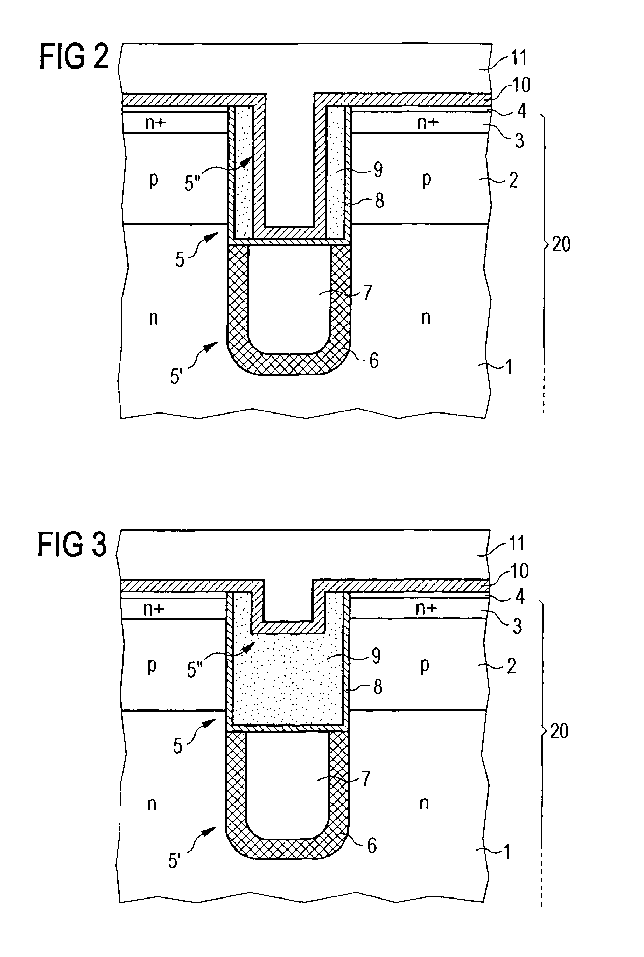

Figur 2 zeigt eine vereinfachte Schnittansicht der erfindungsgemäßen vertikalen nichtflüchtigen Halbleiter-Speicherzelle gemäß einem ersten Ausführungsbeispiel.

Gemäß Figur 2 besteht ein Halbleitersubstrat 20 aus einer n-dotierten Basisschicht 1 und einer darauf epitaktisch abgeschiedenen p-dotierten Halbleiterschicht 2 mit darin ausgebildeten n⁺-Gebieten 3. Vorzugsweise besteht das Halbleitersubstrat 1 aus Si. Es kann jedoch auch SiGe, SiC, GaAs oder einen sonstigen Verbund-Halbleiter aufweisen sowie in einen Mehrschichtaufbau aus isolierenden, halbleitenden und leitenden Schichten, beispielsweise nach Art von SOS und SOI, eingebettet sein. In gleicher Weise kann auch eine umgekehrte Dotierung für die Gebiete 1, 2 und 3 verwendet werden, wodurch sich eine p-n-p-Schichtenfolge ergibt. In gleicher Weise kann die Halbleiterschicht 2 auch durch eine Diffusion oder anderweitig ausgebildet werden.

Unter Verwendung einer Hilfsschicht 4 und einer nicht dargestellten Maskenschicht wird eine Vertiefung im Halbleitersubstrat 20 ausgebildet, die sich bis in die Basisschicht 1 erstreckt. Der untere Teil dieser Vertiefung stellt hierbei den späteren Grabenfortsatz 5' dar, während ein oberer Teil den Graben 5 für die eigentliche vertikale nichtflüchtige Halbleiter-Speicherzelle realisiert.

Der Grabenfortsatz 5' ist hierbei an seiner Oberfläche mit einer dritten dielektrischen Schicht 6 beschichtet, die vorzugsweise aus einer ONO-Schichtenfolge besteht (Oxid/Nitrid/Oxid). Der verbleibende Raum des Grabenfortsatzes 5' wird mit einem Füllmaterial 7 aufgefüllt, welches vorzugsweise aus Polysilizium besteht. Es kann jedoch auch aus einem Silizid bestehen wie z.B. MoSi, WSi, usw., oder ein elektrisch isolierendes Material aufweisen. Vorzugsweise wird die dritte dielektrische Schicht 6 und das Füllmaterial 7 im gesamten Graben 5 und 5' ausgebildet und anschließend mittels eines geeigneten Ätzverfahrens bis auf eine Tiefe knapp unterhalb der eine Kanalschicht realisierenden p-dotierten Schicht 2 eingesenkt. An der Oberfläche des derart ausgebildeten Grabens 5 wird anschließend beispielsweise durch eine thermische Oxidation eine erste dielektrische Schicht 8 ausgebildet, die als Tunnelschicht der vertikalen nichtflüchtigen Halbleiter-Speicherzelle wirkt. Vorzugsweise besteht diese Tunnelschicht 8 aus SiO₂, wobei jedoch auch andere geeignete dünne Tunnelschichten verwendet werden können.

Zur Verbesserung der Isolation des Grabenfortsatzes 5' kann vor oder während der Erzeugung der ersten dielektrischen Schicht 8 an der Oberkante des Füllmaterials 7 und der unmittelbar angrenzenden Wand des Grabens 5, z.B. bis zur Oberkante der Schicht 1, eine nicht dargestellte Verstärkung der ersten dielektrischen Schicht vorgesehen werden. Diese kann vorteilhaft unter Ausnutzung z.B. unterschiedlicher Oxidationsraten von Füllmaterial 7 und der Halbleiterschichten 1 und 2 erzielt werden. Ebenso sind geeignete Kombinationen aus Abscheide- und Ätzprozessen, insbesondere unter Ausnutzung einer Anisotropie, zur Herstellung der Verstärkung möglich.

Gemäß Figur 2 wird ferner der Graben 5 mit einer beispielsweise aus Polysilizium oder einem Silizid bestehenden Ladungsspeicherschicht 9 aufgefüllt und anschließend geätzt oder lediglich die Seitenwände des Grabens 5 beschichtet, wodurch ein Steuerschichtgraben 5" ausgebildet wird. Gemäß Figur 2 reicht dieser Steuerschichtgraben 5" bis zum Boden des Grabens 5. An den Seitenwänden des Steuerschichtgrabens 5" wird eine zweite dielektrische Schicht 10 ausgebildet, die beispielsweise wiederum aus einer ONO-Schichtenfolge besteht. Zur Erhöhung eines Koppelfaktors der nichtflüchtigen Halbleiter-Speicherzelle kann jedoch diese zweite dielektrische Schicht 10 auch aus einem Dielektrikum mit hoher relativer Dielektrizitätskonstante □ᵣ bestehen, wobei insbesondere Metalloxide verwendet werden können. Derartige für die zweite dielektrische Schicht 10 verwendbare Metalloxide sind beispielsweise TiO₂, WOₓ, Al₂O₃ usw.

Anschließend wird der Steuerschichtgraben 5" mit einer elektrisch leitenden Steuerschicht 11 bzw. Steuerfüllschicht 11' aufgefüllt, welche einen sogenannten Steuer-Gate-Anschluß der nichtflüchtigen Halbleiter-Speicherzelle realisiert. Diese Steuerschicht 11 bzw. Steuerfüllschicht 11' besteht beispielsweise aus hochdotiertem Polysilizium, kann jedoch auch aus jedem weiteren elektrisch leitenden Material z.B. Silizid bestehen. Darüber hinaus kann für die in dem Steuerschichtgraben 5" befindliche Steuerfüllschicht 11' ein vom Oberflächenmaterial 11 verschiedenes Material verwendet werden, wodurch sich insbesondere bei sehr feinen Strukturen eine optimale Verfüllung und damit Kontaktierung realisieren lässt. Die Verfüllung des Steuerschichtgrabens 5" läßt sich in gleicher Weise auch aus mehr als zwei Schichten aufbauen.

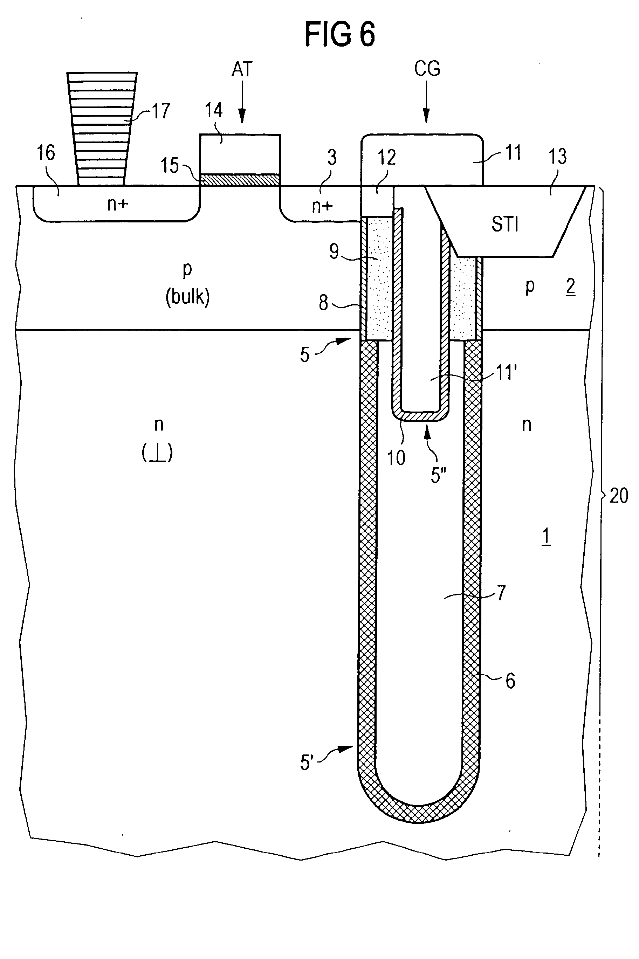

Auf diese Weise erhält man eine vertikale nichtflüchtige Halbleiter-Speicherzelle, deren Kanallänge im Wesentlichen durch die Dicke der Schicht 2 bestimmt wird. Durch die Verwendung der Basisschicht 1 kann Platz für einen Kontakt eingespart werden, wobei ferner durch die Verlagerung der Ladungsspeicherschicht 9 in den Graben eine zusätzliche Topologiestufe an der Oberfläche vermieden wird und somit eine Shrink-Fähigkeit verbessert wird. Ferner erhöhen sich jedoch insbesondere durch den Grabenfortsatz 5' mit seiner zusätzlichen dielektrischen Schicht 6 und dem darin befindlichen Füllmaterial 7 die Datenhalteeigenschaften der Halbleiter-Speicherzelle, wodurch sich insbesondere die sogenannte "retention time" verbessert. Darüber hinaus ist eine derartige nichtflüchtige Halbleiter-Speicherzelle mit geringen Kosten herstellbar, da das Ausbilden von derartigen tiefen Gräben bzw. Vertiefungen mit der dazugehörigen dielektrischen Schicht und dem Füllmaterial aus einer Vielzahl von Standardprozessen bereits bekannt ist und somit keine Mehrkosten verursacht. Eine detaillierte Beschreibung dieses Vorteils erfolgt nachstehend anhand von Figur 6.

Figur 3 zeigt eine vereinfachte Schnittansicht einer erfindungsgemäßen vertikalen nichtflüchtigen Halbleiter-Speicher zelle gemäß einem zweiten Ausführungsbeispiel, wobei gleiche Bezugszeichen gleiche Schichten bzw. Elemente beschreiben und auf eine wiederholte Beschreibung nachfolgend verzichtet wird.

Gemäß Figur 3 besteht der wesentliche Unterschied dieses zweiten Ausführungsbeispiels gegenüber der Halbleiter-Speicherzelle gemäß Figur 2 darin, dass der Steuerschichtgraben 5" nur teilweise in die Ladungsspeicherschicht 9 eingesenkt ist, wodurch sich für bestimmte Materialien verbesserte Ladungshalteeigenschaften sowie Programmiereigenschaften ergeben können. Im nicht dargestellten Extremfall kann hierbei der Steuerschichtgraben 5" nahezu entfallen, wodurch die zweite dielektrische Schicht 10 vollständig parallel zur Oberfläche des Halbleitersubstrats verläuft und die Topologieeigenschaften stark verbessert sind. Insbesondere bei stark topologieabhängigen Materialien ergibt sich dadurch eine wesentliche Vereinfachung und Verbesserung des Herstellungsprozesses, wobei jedoch ein Koppelfaktor in der Regel verschlechtert ist.

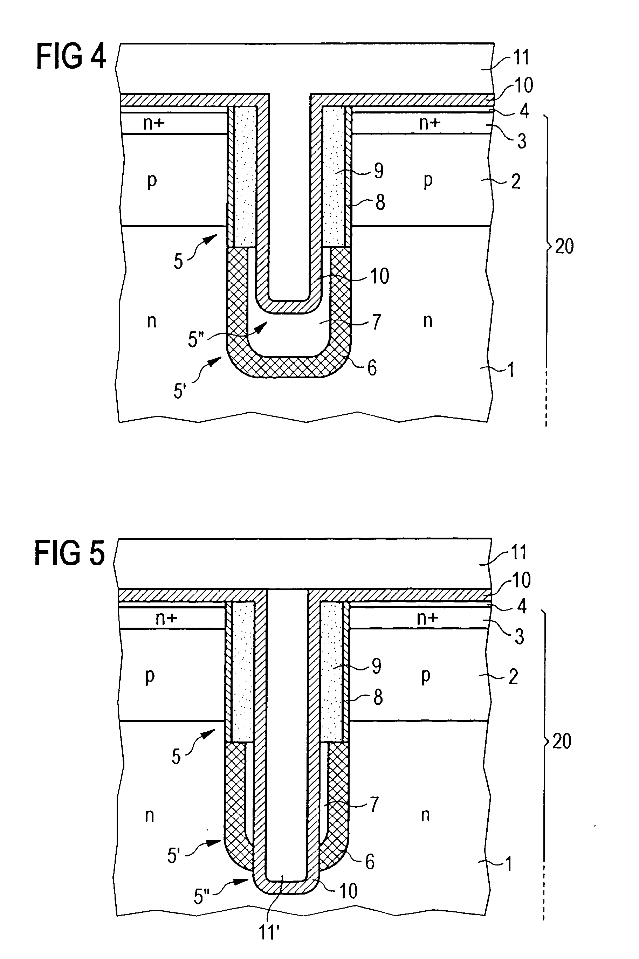

Figur 4 zeigt eine vereinfachte Schnittansicht einer erfindungsgemäßen vertikalen nichtflüchtigen Halbleiter-Speicherzelle gemäß einem dritten Ausführungsbeispiel, wobei wiederum gleiche Bezugszeichen gleiche Schichten oder Elemente bezeichnen und auf eine wiederholte Beschreibung nachfolgend verzichtet wird.

Gemäß Figur 4 kann nunmehr die am Boden existierende erste dielektrische Schicht 8 entfallen und eine direkte Kontaktierung zwischen dem Füllmaterial 7 und der Ladungsspeicherschicht 9 durchgeführt werden. Bei Verwendung von entsprechenden Materialien wie beispielsweise hochdotiertem Polysilizium (leitend) für sowohl die Ladungsspeicherschicht 9 als auch das Füllmaterial 7 kann dadurch der Koppelfaktor der Halbleiter-Speicherzelle wesentlich verbessert werden.

Darüber hinaus kann sich jedoch auch der Steuerschichtgraben 5" bis in das Füllmaterial 7 erstrecken, wodurch sich ein Koppelfaktor weiter optimieren lässt und darüber hinaus ein Ätzprozessfenster zum Ausbilden des Steuerschichtgrabens 5" wesentlich entspannt werden kann. Die Herstellungskosten können dadurch weiter verringert werden. Gleichwohl werden insbesondere durch die Verwendung der dritten dielektrischen Schicht 6 weiterhin die Datenhalteeigenschaften der Halbleiter-Speicherzelle im Gegensatz zu herkömmlichen vertikalen Halbleiter-Speicherzellen verbessert.

Figur 5 zeigt eine vereinfachte Schnittansicht einer erfindungsgemäßen vertikalen nichtflüchtigen Halbleiter-Speicherzelle gemäß einem vierten Ausführungsbeispiel, wobei wiederum gleiche Bezugszeichen gleiche Schichten bezeichnen und auf eine wiederholte Beschreibung nachfolgend verzichtet wird.

Gemäß dem in Figur 5 dargestellten vierten Ausführungsbeispiel erstreckt sich der Steuerschichtgraben 5" von der Oberfläche des Halbleitersubstrats 20 durch die Ladungsspeicherschicht 9 und das Füllmaterial 7 bis in das Substrat bzw. die Basisschicht 1 hinein. Bei einer derartigen Halbleiter-Speicherzelle erhält man ein besonders entspanntes Ätzprozessfenster für den Steuerschichtgraben 5", wodurch sich die Herstellungskosten weiter verringern lassen. Darüber hinaus kann bei Verwendung von geeigneten Materialien ein Koppelfaktor der Halbleiter-Speicherzelle weiter verbessert werden, da die Oberfläche zwischen der Steuerschicht 11 bzw. der im Steuerschichtgraben 5" verwendeten Steuerfüllschicht 11' weiter vergrößert ist. Insbesondere bei Verwendung von hochdotiertem Polysilizium als Ladungsspeicherschicht 9 und als Füllmaterial 7 wirken diese nunmehr gemeinsam als Ladungsspeicherschicht, wobei insbesondere auf Grund der dritten dielektrischen Schicht 6 weiterhin die Datenhalteeigenschaften und somit die "retention-time" der Halbleiter-Speicherzelle verbessert sind.

Gemäß Figuren 2 bis 5 wurde jeweils eine Hilfsschicht 4 zur Maskierung verwendet; diese kann jedoch auch entfallen. Ferner kann an Stelle einer elektrisch leitenden Ladungsspeicherschicht 9 (hochdotiertes Polysilizium) auch eine nicht leitende Ladungsspeicherschicht (z.B. Nitrid) oder ein sonstiges ladungsspeicherndes Material verwendet werden.

Nachfolgend wird eine vertikale nichtflüchtige Halbleiter-Speicherzelle mit einem dazugehörigen Auswahltransistor als EEPROM-Speicherzelle gemäß einem bevorzugten fünften Ausführungsbeispiel beschrieben.

Figur 6 zeigt eine vereinfachte Schnittansicht dieses bevorzugten fünften Ausführungsbeispiels, wobei gleiche Bezugszeichen wiederum gleiche Schichten oder Elemente bezeichnen und auf eine wiederholte Beschreibung nachfolgend verzichtet wird. Gemäß Figur 6 wird die vertikale nichtflüchtige Halbleiter-Speicherzelle unmittelbar in einen DRAM-Prozess eingebunden, wodurch sich die Herstellungskosten auf Grund bereits bekannter Prozessfolgen weiter verringern lassen und die nichtflüchtige Halbleiter-Speicherzelle in einem sogenannten embedded DRAM-Prozess hergestellt werden kann. Genauer gesagt können somit auf einem gleichen Wafer sowohl DRAM-Speicherzellen als auch nichtflüchtige vertikale Halbleiter-Speicherzellen mit verbesserten Datenhalteeigenschaften auf besonders kostengünstige Art und Weise hergestellt werden.

Gemäß Figur 6 besitzt die EEPROM-Halbleiter-Speicherzelle einen sehr ähnlichen Aufbau zu einer herkömmlichen DRAM-Halbleiter-Speicherzelle mit einem Grabenkondensator. Genauer gesagt werden zur Ausbildung des Grabenfortsatzes 5' und des Grabens 5 die gleichen Prozesse wie für den Grabenkondensator in einer DRAM-Speicherzelle verwendet, wobei zunächst ein tiefer Graben im Halbleitersubstrat 20 frei gelegt wird und dieser anschließend mit einer dielektrischen Schicht 6 und einem elektrisch leitenden Füllmaterial 7 zumindest teilweise aufgefüllt wird. Der tiefe Graben kann hierbei eine nicht dargestellte Flaschenform aufweisen und auch eine bei DRAM-Speicherzellen notwendige nicht dargestellte vergrabene Platte besitzen.

Das Ausbilden des tiefen Grabens 5 bzw. 5', der dritten dielektrischen Schicht 6, des Füllmaterials 7 sowie das Einsenken des Füllmaterials 7 und Entfernen der dritten dielektrischen Schicht 6 im oberen Bereich des Grabens entspricht somit den entsprechenden Schritten bei der Herstellung eines DRAM-Grabenkondensators. Auf eine detaillierte Beschreibung wird nachfolgend verzichtet, da diese dem Fachmann hinreichend bekannt sind.

Bei dem erfindungsgemäßen Verfahren zur Herstellung der vertikalen nichtfluchtigen Halbleiter-Speicherzelle wird jedoch an Stelle der Herstellung des Isolationskragens (bzw. collars) im DRAM-Prozess die erste dielektrische Schicht 8 vorzugsweise als SiO₂-Tunnelschicht an den Grabenwänden des Grabens 5 ausgebildet und anschließend mit einer Ladungsspeicherschicht 9, die vorzugsweise aus hochdotiertem Polysilizium besteht, aufgefüllt. Die hochdotierte Polysiliziumschicht 9 liegt hierbei unmittelbar auf der als Füllmaterial 7 dienenden (evtl. hochdotierten) Polysiliziumschicht des Grabenfortsatzes 5' auf, wodurch sich eine virtuell vergrößerte Ladungsspeicherschicht 9 bzw. 7 ergibt. Anschließend wird vorzugsweise durch einen anisotropen Ätzprozess ein Steuerschichtgraben 5" zumindest teilweise in der Ladungsspeicherschicht 9 ausgebildet, wobei er gemäß Figur 6 bis in das Füllmaterial 7 hinein reicht. Anschließend wird die zweite dielektrische Schicht 10 im Steuerschichtgraben 5" ausgebildet, wobei vorzugsweise eine ONO-Schichtenfolge oder ein Dielektrikum mit hoher relativer Dielektrizitätskonstante □ᵣ verwendet wird. Anschließend wird im verbleibenden Steuerschichtgraben 5" eine (Füll-)Steuerschicht 11' ausgebildet, die vorzugsweise aus einem elektrisch leitenden Polysilizium besteht.

Eine Steuer-Gate-Schicht 11 befindet sich an der Oberfläche des Substrats und kontaktiert die (Füll-)Steuerschicht 11' zur Realisierung eines Steuergates CG der nichtflüchtigen Halbleiter-Speicherzelle. Zur Vermeidung von unerwünschten Leckströmen an der Oberfläche befindet sich an einem oberen Bereich des Grabens 5 ein Isolationskragen 12. Die weiteren Elemente wie beispielsweise der Auswahltransistor AT bestehend aus einem Gate 14 einer Isolationsschicht 15 sowie Drain- und Sourcegebieten 3 und 16 mit einem Kontaktanschluss 17 werden wiederum mit einem herkömmlichen DRAM-Prozess ausgebildet. In gleicher Weise werden nicht dargestellte jeweils benachbarte vertikale nichtflüchtige Halbleiter-Speicherzellen durch eine im DRAM-Prozess vorhandene flache Gabenisolation 13 (STI, shallow trench isolation) voneinander getrennt.

Wie bei den Ausführungsbeispielen gemaß Figur 2 bis 5 kann der Steuerschichtgraben 5" unterschiedlich tief ausgebildet sein, wodurch sich insbesondere ein Ätzprozessfenster für diesen Graben wesentlich entspannen lasst. Der wesentliche Vorteil dieses fünften Ausführungsbeispiels liegt hierbei darin, dass ein ohnehin vorhandener DRAM-Prozess zum Ausbilden von Grabenkondensatoren für die erfindungsgemäße vertikale nichtflüchtige Halbleiter-Speicherzelle verwendet werden kann, wobei sich verbesserte Datenhalteeigenschaften ergeben. Darüber hinaus wird dadurch ein eingebetteter bzw. embedded DRAM-Prozess ermöglicht, bei dem im gleichen Halbleitersubstrat sowohl nichtflüchtige als auch dynamische Halbleiter-Speicherzellen realisiert werden können. Insbesondere in Smartcards und Chipkarten sind dadurch neue Schaltungen realisierbar.

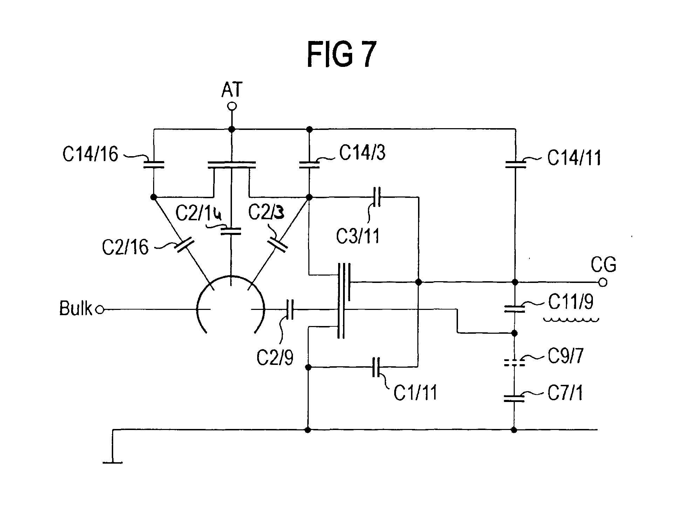

Nachfolgend wird zur Veranschaulichung des Einflusses der jeweiligen Schichten auf einen Koppelfaktor ein Ersatzschaltbild gemäß Figur 7 der in Figur 6 dargestellten EEPROM-Halbleiter-Speicherzelle beschrieben.

Gemäß Figur 7 bezeichnen die Indizes der Kondensatoren die jeweiligen Schichten bzw. Gebiete von Figur 6, die diese Kapazitäten erzeugen. Demzufolge besitzt der Auswahltransistor AT parasitäre Kapazitäten C_{14/16} und C_{14/3} zum Drain- und Sourcegebiet 16 und 3. Ferner existieren parasitäre Kapazitäten C_{2/16}, C_{2/14}, C_{2/9} und C_{2/3} zur epitaktisch aufgewachsenen p-Schicht 2 (bulk), welche als Kanalschicht dient. Die eigentliche nichtflüchtige vertikale Halbleiter-Speicherzelle besitzt parasitäre Kapazitäten C_{3/11} und C_{1/11} von der Steuerschicht 11 bzw. 11' zum n⁺-Gebiet 3 und zur n-Basisschicht 1. Eine weitere parasitäre Kapazität C_{14/11} liegt zwischen der Steuerschicht 11 und der Steuer-Gate-Schicht 14 des Auswahltransistors, wobei die Kapazität C_{7/1} eine Kapazität zwischen dem Füllmaterial und der n-Basisschicht 1 darstellt. Bei Verwendung einer optionalen Isolierschicht zwischen dem Füllmaterial 7 und der Ladungsspeicherschicht 9 existiert zusätzlich die Kapazität C_{9/7} zwischen diesen beiden Materialien.

Um einen möglichst hohen Koppelfaktor zu erhalten, muss insbesondere eine Kapazität C_{11/9} zwischen der Steuerschicht 11 bzw. 11' und der Ladungsspeicherschicht 9 möglichst groß sein bzw. die Gesamtkapazität der restlichen Kapazitäten möglichst gering sein. In Kenntnis dieses Zusammenhangs kann unter Verwenden von geeigneten Materialien für die jeweiligen Schichten sowie Gebiete und durch Variierung der Tiefe des Steuerschichtgrabens 5" ein optimaler bzw. maximaler Koppelwert bzw. Koppelfaktor eingestellt werden. Auf diese Weise erhält man neben den verbesserten Datenhalteeigenschaften darüber hinaus besonders günstige Programmierspannungen.

## Patentansprüche

1. Vertikale nichtflüchtige Halbleiter-Speicherzelle mit einem Substrat (20), das ein Draingebiet (1), ein Kanalgebiet (2) und ein Sourcegebiet (3) aufweist;
einem Graben (5), der im Wesentlichen senkrecht zu einer Oberfläche des Substrats (20) vom Sourcegebiet (3) bis zum Draingebiet (1) vertikal ausgebildet ist;
einer ersten dielektrischen Schicht (8), die im Wesentlichen an den Grabenwänden ausgebildet ist;
einer Ladungsspeicherschicht (9) zum Speichern von Ladungen, die im Wesentlichen an der ersten dielektrischen Schicht (8) ausgebildet ist;
einer zweiten dielektrischen Schicht (10), die zumindest teilweise an einer Oberfläche der Ladungsspeicherschicht (9) ausgebildet ist; und
einer Steuerschicht (11, 11'), die im Wesentlichen an einer Oberfläche der zweiten dielektrischen Schicht (10) ausgebildet ist, **gekennzeichnet durch**
einen Grabenfortsatz (5'), der im Wesentlichen unterhalb des Grabens (5) ausgebildet ist, und eine dritte dielektrische Schicht (6) an seiner Grabenoberfläche sowie ein Füllmaterial (7) zum zumindest teilweisen Auffüllen des Grabenfortsatzes (5') aufweist.

2. Vertikale nichtflüchtige Halbleiter-Speicherzelle nach Patentanspruch 1,
**dadurch gekennzeichnet, dass** das Füllmaterial (7) des Grabenfortsatzes (5') von der Ladungsspeicherschicht (9) elektrisch isoliert ist.

3. Vertikale nichtflüchtige Halbleiter-Speicherzelle nach Patentanspruch 1,
**dadurch gekennzeichnet, dass** das Füllmaterial (7) des Grabenfortsatzes (5') die Ladungsspeicherschicht (9) elektrisch kontaktiert.

4. Vertikale nichtflüchtige Halbleiter-Speicherzelle nach einem der Patentansprüche 1 bis 3,
**dadurch gekennzeichnet, dass** sich die zweite dielektrische Schicht (10) und die Steuerschicht (11, 11') zumindest teilweise innerhalb des Grabens (5) erstrecken.

5. Vertikale nichtflüchtige Halbleiter-Speicherzelle nach einem der Patentansprüche 1 bis 3,
**dadurch gekennzeichnet, dass** sich die zweite dielektrische Schicht (10) und die Steuerschicht (11, 11') zumindest teilweise innerhalb des Grabens (5) und des Grabenfortsatzes (5') erstrecken.

6. Vertikale nichtflüchtige Halbleiter-Speicherzelle nach einem der Patentansprüche 1 bis 3,
**dadurch gekennzeichnet, dass** sich die zweite dielektrische Schicht (10) und die Steuerschicht (11, 11') zumindest teilweise innerhalb des Grabens (5), des Grabenfortsatzes (5') und des Substrats (20) erstrecken.

7. Vertikale nichtflüchtige Halbleiter-Speicherzelle nach einem der Patentansprüche 1 bis 6,
**dadurch gekennzeichnet, dass** die erste dielektrische Schicht (8) eine Tunnelschicht aufweist.

8. Vertikale nichtflüchtige Halbleiter-Speicherzelle nach einem der Patentansprüche 1 bis 7,
**dadurch gekennzeichnet, dass** die zweite und dritte dielektrische Schicht (10 und 11) eine ONO-Schichtenfolge aufweisen.

9. Vertikale nichtflüchtige Halbleiter-Speicherzelle nach einem der Patentansprüche 1 bis 7,
**dadurch gekennzeichnet, dass** die zweite dielektrische Schicht (10) ein Dielektrikum mit hoher relativer Dielektrizitätskonstante aufweist.

10. Vertikale nichtfluchtige Halbleiter-Speicherzelle nach Patentanspruch 9,
**dadurch gekennzeichnet, dass** die zweite dielektrische Schicht ein Metalloxid aufweist.

11. Vertikale nichtflüchtige Halbleiter-Speicherzelle nach einem der Patentansprüche 1 bis 10, **dadurch gekennzeichnet, dass** das Füllmaterial (7), die Ladungsspeicherschicht (9) und die Steuerschicht (11, 11') elektrisch leitendes Polysilizium oder ein Silizid aufweisen.

12. Vertikale nichtflüchtige Halbleiter-Speicherzelle nach einem der Patentansprüche 1 bis 11,
**dadurch gekennzeichnet, dass** die Steuerschicht eine Oberflächenschicht (11) und zumindest eine Steuerfüllschicht (11') aufweist.

13. Vertikale nichtflüchtige Halbleiter-Speicherzelle nach einem der Patentansprüche 1 bis 12,
**dadurch gekennzeichnet, dass** der Graben (5) und der Grabenfortsatz (5') einen in einem DRAM-Prozess ausgebildeten tiefen Graben darstellen.

14. Verfahren zur Herstellung einer vertikalen nichtflüchtigen Halbleiter-Speicherzelle mit den Schritten:
a) Bereitstellen eines Substrats (20);
b) Ausbilden eines tiefen Grabens (5, 5'), einer dritten dielektrischen Schicht (6) und eines Füllmaterials (7);
c) Einsenken des Füllmaterials (7) und Entfernen der dritten dielektrischen Schicht (6) zum Ausbilden eines Grabens (5) ;
d) Ausbilden einer ersten dielektrischen Schicht (8) im Graben (5);
e) Ausbilden einer Ladungsspeicherschicht (9) im Graben (5) ;
f) Ausbilden eines Steuerschichtgrabens (5") zumindest teilweise in der Ladungsspeicherschicht (9);
g) Ausbilden einer zweiten dielektrischen Schicht (10) im Steuerschichtgraben (5");
h) Ausbilden einer Steuerschicht (11, 11') im Steuerschichtgraben (5"); und
i) Ausbilden einer Kragenisolation (12), einer flachen Grabenisolierung (13) und von Anschlusselementen (14 bis 17).

15. Verfahren nach Patentanspruch 14,
**dadurch gekennzeichnet, dass** der Steuerschichtgraben (5") bis in den Graben (5) geätzt wird.

16. Verfahren nach Patentanspruch 14,
**dadurch gekennzeichnet, dass** der Steuerschichtgraben (5") bis in den tiefen Graben (5, 5') geätzt wird.

17. Verfahren nach Patentanspruch 14,
**dadurch gekennzeichnet, dass** der Steuerschichtgraben (5") bis in das Substrat (20) geätzt wird.
